# FASCICULE DE BREVET EUROPEEN

(11) **EP 4 271 166 B1**
(45) Date de publication et mention de la délivrance du brevet: **25.11.2026**
(21) Numéro de dépôt: 23169902.6
(22) Date de dépôt: 25.04.2023
(51) Int. Cl.: H10N 70/00, H10N 70/20

(54) **PROCÉDÉ DE FABRICATION D'UN MATÉRIAU À CHANGEMENT DE PHASE**
VERFAHREN ZUR HERSTELLUNG EINES PHASENWECHSELMATERIALS
METHOD FOR MANUFACTURING PHASE CHANGE MATERIAL

(30) Priorité: 28.04.2022 FR 2204021
(43) Date de publication de la demande: 01.11.2023
(73) Titulaire: Commissariat à l'Energie Atomique et aux Energies Alternatives, 75015 Paris (FR)
(72) Inventeur: TEREBENEC, Damien, 38054 GRENOBLE Cedex 09 (FR); NOE, Pierre-Olivier, 38054 GRENOBLE Cedex 09 (FR)
(74) Mandataire: Hautier IP

(56) Documents cités:
- CN-A- 110 571 331
- US-A1- 2008 106 923
- US-A1- 2018 033 962
- US-A1- 2021 359 205
- LI HUI ET AL: "Controlled Synthesis of Topological Insulator Nanoplate Arrays on Mica", JOURNAL OF THE AMERICAN CHEMICAL SOCIETY, vol. 134, no. 14, 30 March 2012 (2012-03-30), pages 6132 - 6135, XP093076532, ISSN: 0002-7863, DOI: 10.1021/ja3021395

## Description

### DOMAINE TECHNIQUE

La présente invention concerne, en général, un procédé de fabrication d'un matériau à changement de phase, et plus particulièrement un procédé de fabrication d'un empilement multicouches comprenant des gaps ou pseudo-gaps de van der Waals. Une application particulière liée à la mise en oeuvre de ce procédé est la fabrication de mémoires à changement de phase.

### ETAT DE LA TECHNIQUE

Les matériaux à changement de phase PCM (acronyme de Phase Change Material) font désormais l'objet de nombreuses applications dans le domaine des mémoires à changement de phase en microélectronique et en photonique ou pour les convertisseurs thermoélectriques.

Dans le domaine des mémoires à changement de phase en particulier, les matériaux les plus étudiés sont les alliages de PCM polycristallin situés sur la ligne pseudo-binaire GeTe-Sb₂Te₃ du diagramme ternaire Ge-Sb-Te. L'un de ces matériaux le plus connu est le Ge₂Sb₂Te₅. Ces matériaux présentent typiquement un mécanisme de liaison chimique dit « métavalent » qui leur confère des propriétés physiques uniques les différenciant des autres matériaux dits covalents, métalliques, etc ... Certaines phases cristallographiques de ces matériaux PCM permettent d'accommoder les lacunes présentes dans le réseau cristallin en adoptant une structure sous forme de feuillets faiblement liés entre eux par des liaisons homopolaires très faiblement covalentes ou de type van der Waals. Ces liaisons faibles entre feuillets ou blocs cristallins dans la structure du matériau PCM sont appelées gaps ou pseudo-gaps de van der Waals.

Le document « R. E. Simpson et al., Nature nanotechnology 2011, 6, 501 » divulgue une méthode de structuration améliorée de ces matériaux PCM. Dans ce document, la couche de Ge₂Sb₂Te₅ polycristalline (servant de référence) des dispositifs mémoire à changement de phase est remplacée par une hétérostructure multicouches de composition chimique globale équivalente et comprenant des couches cristallines de (GeTe)₂ et Sb₂Te₃ alternées. Une telle hétérostructure comprend également des pseudo-gaps de van der Waals s'étendant au sein des couches et/ou entre les couches alternées. Une telle hétérostructure correspond typiquement à un super-réseau (SL pour Super-Lattice) et est également appelée iPCM (interfacial Phase Change Material).

Cette solution basée sur les SL permet de réduire de 40% le courant de programmation, d'augmenter la vitesse de programmation, et d'améliorer l'endurance du dispositif mémoire, en comparaison du dispositif intégrant la référence PCM de Ge₂Sb₂Te₅. Depuis 2011, cet effet des SL sur l'amélioration des performances des dispositifs mémoire a été confirmé par de nombreux groupes dans le monde mais le mécanisme à l'origine de l'amélioration des performances dans les dispositifs intégrant des SL reste toujours très débattu. Il apparaît cependant de façon consensuelle que les meilleures performances sont obtenues soit en augmentant la proportion de Sb₂Te₃ dans le super réseau en utilisant par exemple des couches de Sb₂Te₃ de plus grande épaisseur (4 nm au lieu de 1 nm, ou 8 nm au lieu de 4 nm ou 2 nm par exemple), soit en réduisant l'épaisseur de la couche de GeTe.

D'autres procédés de l'art antérieur sont décrits par US 2021 / 0359205 A1, CN 110 571 331 A, US 2018 / 0033962 A1 et US 2008 / 0106923 A1.

Un objectif de la présente invention est d'améliorer les performances des SL à changement de phase, en particulier pour des hétérostructures présentant des couches de faibles épaisseurs, notamment inférieures à 8 nm.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de réalisation d'un empilement (iPCM) à changement de phase comprenant au moins :
- une première couche d'un premier matériau A,
- une deuxième couche d'un deuxième matériau B, différent du premier matériau A,
ledit empilement présentant une structure cristallographique en feuillets séparés par des pseudo-gaps de van der Waals.

Le procédé comprend au moins les étapes suivantes :
- Une fourniture d'un substrat,
- Une formation de l'empilement sur une surface du substrat, ladite formation comprenant au moins :
   ∘ Une formation de la première couche,
   ∘ Une formation de la deuxième couche sur la première couche.

Avantageusement, dans ce procédé, au moins un recuit de guérison est effectué après formation de l'empilement. Le recuit de guérison est tel que l'empilement présente, après ledit recuit, un taux de défauts nominal inférieur à 50% d'un taux de défauts initial de l'empilement, pris avant ledit recuit.

Les travaux de l'art antérieur enseignent que les meilleures performances sont obtenues en augmentant l'épaisseur des couches Sb₂Te₃. Le mécanisme sous-jacent à cette augmentation de performances, selon l'art antérieur, est la diminution de la barrière d'énergie nécessaire à faire transiter les couches de GeTe d'une structure cristallographique à une autre, sous l'effet de la contrainte mécanique exercée par les couches Sb₂Te₃ de plus grandes épaisseurs sur la couche de GeTe.

Contrairement à l'approche retenue dans l'art antérieur, il a été observé dans le cadre du développement de la présente invention que la présence de défauts structuraux, et en particulier de fautes d'empilement dans l'hétérostructure contribuait de façon significative et insoupçonnée à la diminution des performances des couches Sb₂Te₃, en particulier pour des couches Sb₂Te₃ de faibles épaisseurs inférieures ou égales à 8 nm.

En outre les investigations menées dans le cadre de la présente invention ont montré que ce sont essentiellement les fautes d'empilement et défauts dans le réseau cristallin qui sont à l'origine d'une perte des propriétés électroniques et thermiques avantageuses pour les applications des PCM.

Parmi les différentes solutions possibles pour limiter ou éviter la présence de défauts structuraux et améliorer la qualité cristalline de l'empilement, il a été avantageusement choisi de mettre en oeuvre dans le cadre de l'invention un recuit de guérison de ces défauts structuraux, après formation de l'empilement. Ainsi, contrairement à certaines solutions de l'art antérieur, la stœchiométrie de l'empilement est conservée.

De préférence, une étape de contrôle par diffraction des rayons X est effectuée suite au recuit de guérison, afin de vérifier que le taux de défauts de l'empilement a effectivement diminué. Un ou plusieurs autres recuits peuvent être réalisés si le taux de défauts structuraux dans l'empilement n'a pas suffisamment diminué ou n'a pas atteint un taux jugé acceptable selon l'application visée pour un tel empilement. De préférence, le ou les recuits sont répétés ou prolongés de façon à atteindre un taux de défauts nul.

Selon une possibilité, le recuit de guérison est effectué à une température inférieure ou égale à 500°C, de préférence inférieure ou égale à 450°C, et de préférence strictement supérieure à 300°C. De telles températures permettent notamment au procédé d'être mis en œuvre lors des étapes de fin de ligne, dites BEOL (acronyme de « Back End Of Line »), dans les technologies de fabrication de la microélectronique.

Le recuit de guérison n'est pas un recuit de simulation. Il ne vise pas à simuler sur la structure un budget thermique appliqué lors d'étapes de BEOL par exemple.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre en coupe transverse un empilement iPCM selon un mode de réalisation de la présente invention.
La figure 2 est une image de microscopie électronique en transmission à balayage (STEM) en coupe transverse d'un empilement iPCM avant recuit de guérison selon un mode de réalisation la présente invention.
La figure 3 illustre des courbes R(I) pour différents empilements PCM et iPCM, avec ou sans recuit de guérison, selon un mode de réalisation la présente invention.
La figure 4 illustre des diffractogrammes réalisés sur un empilement iPCM avant et après recuit de guérison, selon un mode de réalisation de la présente invention.
Les figures 5A, 5B, 5C, 5D illustrent des analyses par microscopie électronique en transmission (TEM) effectuées différents empilements iPCM avant et après recuit de guérison, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le procédé comprend en outre, après le recuit de guérison, une étape de contrôle par diffraction des rayons X (DRX) de la qualité cristalline de l'empilement.

Selon un exemple, le procédé comprend en outre, après l'au moins un recuit de guérison, une détermination du taux de défauts dans l'empilement basée sur une mesure par diffraction des rayons X (DRX). Cela permet de contrôler que le taux de défauts structuraux de l'empilement a effectivement diminué suite au recuit de guérison. Selon un exemple, un recuit de guérison supplémentaire est effectué si le taux de défauts déterminé est supérieur au taux de défauts nominal. Le recuit de guérison supplémentaire peut être effectué à une température supérieure et/ou pendant une durée plus longue que le premier recuit de guérison. En particulier, lorsque le diagramme de diffraction n'évolue plus avant et après recuit, le taux de défauts est considéré comme minimal ou nul.

Selon un exemple, le procédé comprend en outre, après l'au moins un recuit de guérison, une détermination du taux de défauts dans l'empilement basée sur une observation par microscopie électronique, notamment par microscopie électronique en transmission. Selon un exemple, la détermination du taux de défauts dans l'empilement est effectuée par diffraction des rayons X et par microscopie électronique en transmission. En effet, dans certains cas, les pics de Bragg du diagramme de diffraction sont totalement affinés alors que certains défauts structuraux subsistent dans l'empilement, notamment lorsque les défauts cristallins se présentent sous forme de bicouches inversées appelées « swapped bilayers ». L'analyse complémentaire par microscopie électronique en transmission permet de déterminer si ce type de défauts non décelables par DRX est encore présent dans l'empilement à l'issue du recuit de guérison. Une telle analyse complémentaire est particulièrement avantageuse pour évaluer l'efficacité du recuit de guérison, qui conditionne en partie les propriétés électroniques et thermiques du matériau et par suite les performances des dispositifs basés sur ce matériau.

Selon un exemple, le procédé comprend en outre, après l'au moins un recuit de guérison, une pluralité d'étapes d'intégration de l'empilement destinées à former un dispositif à changement de phase à base dudit empilement, tel qu'une mémoire à changement de phase ou un convertisseur thermoélectrique. La pluralité d'étapes d'intégration peut typiquement comprendre d'autres recuits distincts du recuit de guérison.

Selon un exemple, le procédé comprend en outre, après formation de l'empilement et avant l'étape de recuit de guérison, une formation d'une couche d'électrode supérieure sur l'empilement. La formation de la couche d'électrode supérieure avant l'étape de recuit de guérison permet d'éviter l'oxydation de la surface et/ou une évaporation des atomes les plus volatils de l'empilement, notamment des atomes de tellure. Cela permet de conserver la stoechiométrie de l'empilement.

Selon un exemple, les matériaux A et B sont choisis parmi le tellure (Te), l'antimoine (Sb), les alliages binaires Ge-Sb, Ga-Sb, Ge-Te, Ge-Se, GeSe₂, Sb-Te, Sb-Se, As-Se, As-Te, Sn-Se, Sn-Te, Bi-Se, Bi-Te, Ga-Te, Ga-Se, Pb-Te, In-Se, Pb-Se, Zr-Te, Zr-Se, Ti-Te, Ti-Se, Si-Te, Al-Te, Mo-Te, Mo-Se, W-S, W-Se, les alliages ternaires Ge-Sb-Te, Ge-Se-Te, Ag-Sb-Te, Ge-Bi-Te, Ge-Sb-Se et quaternaire Ge-Sb-Se-Te, et un mélange de ces alliages. En particulier, le matériau A est un matériau bidimensionnel (2D) choisi parmi :
- les dichalcogénures de métaux de transition MX₂ (avec M = Mo, W, et X = S, Se ou Te), le Graphène, le Benzène, le Phosphorène, le Germanène, le Silicène, le Stannène, le Borophène, h-BN, ou
- les alliages de chalcogénures 2D comme Sb-Te, Bi-Te, As-Se, As-Te, Ge-Sb-Te et leur alliages.

Le matériau B est typiquement choisi parmi les matériaux bidimensionnels (2D) ou tridimensionnels (3D) tels que les alliages Ge-Sb, Ga-Sb, Ge-Te, Ge-Se,Ge-Se, Sb-Te, Sb-Se, As-Se, As-Te, Sn-Se, Sn-Te, Bi-Se, Bi-Te, Ga-Te, Ga-Se, Pb-Te, In-Se, Pb-Se, Zr-Te, Zr-Se, Ti-Te, Ti-Se, Si-Te, Al-Te, Mo-Te, Mo-Se, W-S, W-Se, les alliages ternaires Ge-Sb-Te, Ge-Se-Te, Ag-Sb-Te, Ge-Bi-Te, Ge-Sb-Se et quaternaire Ge-Sb-Se-Te, et un mélange de ces alliages.

Selon un exemple, la première couche à base du matériau A et/ou la deuxième couche à base du matériau B sont déposées par épitaxie de van der Waals.

Selon un exemple, le recuit de guérison est effectué à une température inférieure ou égale à 500°C, de préférence inférieure ou égale à 450°C. Cela permet au procédé d'être mis en œuvre lors des étapes de fin de ligne BEOL (acronyme de « Back End Of Line »), dans les technologies de fabrication de la microélectronique.

Selon un exemple, la température du recuit de guérison est supérieure à une température maximale de formation de l'empilement.

Selon un exemple, la température du recuit de guérison est strictement supérieure à 300°C.

Selon un exemple, le recuit de guérison est maintenu à ladite température pendant une durée strictement supérieure à 20 min, de préférence supérieure ou égale à 1h.

Selon un exemple, le recuit de guérison est effectué, en particulier ses paramètres sont réglés, de sorte que l'empilement présente, après ledit recuit, un taux de défauts nominal inférieur à au moins 50% d'un taux de défauts initial de l'empilement, pris avant ledit recuit. Ces paramètres sont pris parmi certains au moins de : la température, la durée, la courbe d'évolution de la température en fonction du temps par exemple une rampe de montée ou de descente en température. Selon un exemple, le recuit de guérison est effectué de sorte que l'empilement présente, après ledit recuit, un taux de défauts nominal inférieur à 40% du taux de défauts initial de l'empilement, pris avant ledit recuit. Selon un exemple, le recuit de guérison est effectué de sorte que l'empilement présente, après ledit recuit, un taux de défauts nominal inférieur à 20%, voire 10% du taux de défauts initial de l'empilement, pris avant ledit recuit.

Selon un exemple, le procédé comprend en outre, avant la formation de l'empilement, une formation d'une couche d'orientation configurée pour orienter l'empilement selon l'axe cristallographique c, la formation de l'empilement se faisant alors sur une surface de ladite couche d'orientation.

Selon un exemple, la couche d'orientation est à base de Sb₂Te₃ ou de Bi₂Te₃ et présente une épaisseur inférieure ou égale à 10 nm.

Selon un exemple, la formation des première et deuxième couches se fait par dépôt des matériaux A et B sous forme amorphe, et la formation de l'empilement comprend en outre, après lesdits dépôts des matériaux A et B sous forme amorphe, un recuit de cristallisation effectué à une température inférieure ou égale à 300°C. Le recuit de cristallisation permet d'obtenir la structure cristallographique de l'empilement, ladite structure étant orientée selon c grâce à la couche d'orientation sous-jacente à l'empilement.

Selon un exemple, le procédé comprend en outre, avant la formation de l'empilement, une étape de passivation au tellure ou à l'antimoine de la surface sur laquelle est formé l'empilement. Cela permet de faciliter la formation de l'empilement par épitaxie dite de van der Waals, où la croissance se fait sous forme de feuillets orientés selon c et séparés par des pseudo-gaps de van der Waals.

Selon un exemple, la formation de l'empilement comprend une pluralité de formations de premières couches alternées avec une pluralité de formations de deuxièmes couches, de sorte à ce que la structure de l'empilement soit multicouches et comprenne une pluralité de premières et deuxièmes couches alternées.

Selon un exemple, certaines au moins des premières couches présentent des épaisseurs différentes, et/ou certaines au moins des deuxièmes couches présentent des épaisseurs différentes, de sorte à ce que la structure multicouches de l'empilement soit apériodique. Une structure multicouches apériodique est plus facile à réaliser qu'une structure multicouches parfaitement périodique. Une contrainte de fabrication est supprimée. Cela facilite la fabrication de l'empilement.

Selon un exemple, le substrat comprend une électrode inférieure configurée pour effectuer un changement de phase localisé de l'empilement.

Selon un exemple, chaque pseudo-gap de van der Waals séparant deux feuillets de la structure cristallographique se présente sous forme d'un espacement entre deux plans purs d'un même type d'atomes, ledit espacement présentant une dimension normale aux plans inférieure ou égale à deux fois le rayon de van der Waals dudit type d'atomes. Les liaisons entre les atomes à travers le pseudo-gap de van der Waals sont typiquement plus courtes et plus fortes que des liaisons de van der Waals ordinaires. Les gaps de van der Waals sont un cas particulier des pseudo-gaps de van der Waals pour lesquels l'espacement présente une dimension normale aux plans égale à deux fois le rayon de van der Waals du type d'atomes. Ainsi, les pseudo-gaps de van der Waals incluent par définition les gaps de van der Waals.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le dispositif ou le procédé, peuvent être adaptées *mutatis mutandis* à l'autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé » se réfèrent à des positions prises selon la direction z.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Dans le cadre de la présente invention, l'empilement présente une structure cristalline multicouches à base de matériaux à changement de phase. Cette structure présente typiquement, dans sa configuration de plus basse énergie, des blocs cristallins orientés selon leur axe cristallographique c et séparés par des liaisons homopolaires très faiblement covalente ou de type van der Waals. Ces liaisons peuvent être par exemple des liaisons Te-Te, Se-Se, ou S-S dans les chalcogénures. Le grand espacement entre les plans liés par ces liaisons est généralement attribué à l'existence d'un plan de lacunes de van der Waals qui est appelé gap ou pseudo-gap de van der Waals (vdW). Cette forme particulière de structure est observée notamment pour les matériaux à changement de phase PCM, les chalcogénures, et plus généralement pour les matériaux présentant un mécanisme de liaison chimique dit « métavalent ». Ces matériaux sont fréquemment décrits comme des matériaux 2D liés par liaison de van der Waals. Cette description peut néanmoins être élargie car la distance entre plans à travers le gap de vdW est généralement plus courte que deux fois le rayon de van der Waals des atomes constituant ces plans. Par exemple dans le cas du tellure, la distance Te-Te à travers le gap de vdW est d'environ 10% plus courte que deux fois le rayon de van der Waals du Te.

Les matériaux de la liste non exhaustive suivante adoptent typiquement, en empilement multicouches, l'hétérostructure à gaps ou pseudo-gaps de vdW décrite ci-dessus : le tellure, l'antimoine, les alliages binaires Ge-Sb, Ga-Sb, Ge-Te, Ge-Se, GeSe₂, Sb-Te, Sb-Se, As-Se, As-Te, Sn-Se, Sn-Te, Bi-Se, Bi-Te, Ga-Te, Ga-Se, Pb-Te, In-Se, Pb-Se, Zr-Te, Zr-Se, Ti-Te, Ti-Se, Si-Te, Al-Te, Mo-Te, Mo-Se, W-S, W-Se, les alliages ternaires Ge-Sb-Te, Ge-Se-Te, Ag-Sb-Te, Ge-Bi-Te, Ge-Sb-Se, quaternaires Ge-Sb-Se-Te voire Ge-Bi-Sb-Te-Se.

Les exemples de réalisation du procédé décrits ci-dessous sont illustrés pour un empilement comprenant des couches GeTe alternées avec des couches Sb₂Te₃. Il est entendu que l'ensemble des matériaux indiqués ci-dessus peut être mis en oeuvre dans le procédé de réalisation d'un empilement multicouches selon l'invention. Les alliages de PCM situés sur la ligne pseudo-binaire GeTe-Sb₂Te₃ du diagramme ternaire Ge-Sb-Te, par exemple le Ge₂Sb₂Te₅, le Ge₁Sb₂Te₄, le Ge₁Sb₄Te₇, sont notamment envisageables pour la mise en oeuvre du procédé. Les alliages tels que le Sb₂Te dopé (Ag,ln), de la famille des AIST, et leurs dérivés sont également envisageables. Les chalcogénures et les sesqui-chalcogénures, tels que Bi₂Te₃, sont également envisageables.

On entend par taux de défauts un nombre de défauts dans la structure cristalline par unité de volume ou, le cas échéant, un nombre de défauts par unité de surface. Un nombre de défauts par unité de volume peut typiquement être estimé par diffraction des rayons X, par exemple à partir de la largeur à mi-hauteur des pics de diffraction *00*/ de la structure cristalline de l'empilement. Un nombre de défauts par unité de surface peut typiquement être quantifié par microscopie électronique en transmission, à partir d'une coupe transverse notamment.

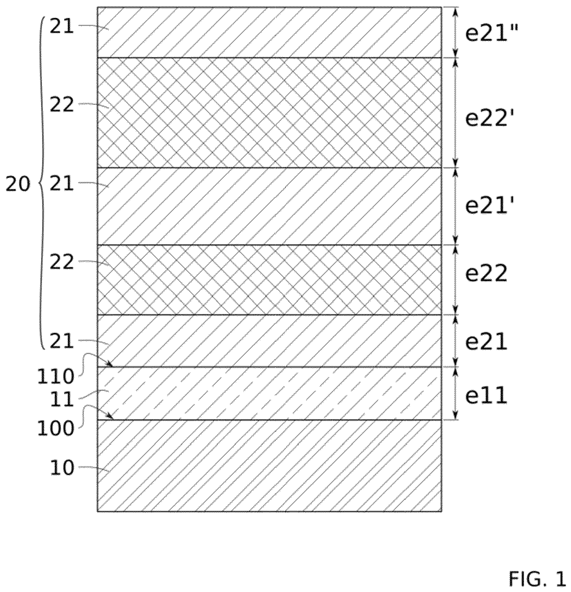

La figure 1 illustre en coupe transverse un empilement 20 de couches 21, 22 alternées de matériaux PCM. Les couches 21 peuvent être ici à base de Sb₂Te₃ et les couches 22 peuvent être à base de GeTe. Trois couches 21 et deux couches 22 sont ici illustrées par souci de clarté. L'empilement 20 comprend typiquement au moins une couche 21 et au moins une couche 22. Le nombre de couches 21, 22 peut être ajusté en fonction de l'épaisseur totale souhaitée pour l'empilement. Les couches 21 présentent typiquement des épaisseurs e21, e21', e21"comprises entre 1 et 20 nanomètres avec une épaisseur proportionnelle à un nombre entier de blocs de van der Waals soit par exemple dans le cas du Sb₂Te₃ où un bloc mesure environ 1 nm selon son axe c : 2 nm, 4 nm, 8 nm ou 16 nm. Ces épaisseurs e21, e21', e21" ne sont pas nécessairement égales entre elles. Les couches 22 présentent typiquement des épaisseurs e22, e22' comprises entre 0,5 et 10 nanomètres d'épaisseur proportionnelle à un nombre de blocs élémentaires de la structure cristalline du matériau de la couche 22, par exemple 0,7 nm dans le cas du GeTe correspondant à un bloc de (GeTe)₂. Ces épaisseurs e22, e22' ne sont pas nécessairement égales entre elles. Lorsque certaines au moins des épaisseurs des couches 21, et/ou certaines moins des épaisseurs des couches 22 ne sont pas égales entre elles, l'empilement 20 est apériodique. Dans le cadre du développement de la présente invention, il a été observé que les performances de l'empilement n'étaient pas liées à la périodicité des couches 21, 22 de matériaux PCM. Cela permet de relâcher la contrainte en précision en épaisseur requise lors de la formation de ces couches 21, 22.

Comme expliqué plus haut, la structure cristalline d'un tel empilement 20 présente des pseudo-gaps de vdW régulièrement distribués le long de la hauteur de l'empilement.

Selon un exemple, l'empilement 20 comprend des blocs de (GeTe)₂ et de Sb₂Te₃ d'épaisseurs respectives 0,7 nm et X nm, notés 0,7/X. La valeur 0,7 nm correspond à l'épaisseur d'un bloc élémentaire de (GeTe)₂ rhomboédrique. La valeur X nm correspond à l'épaisseur des blocs de Sb₂Te₃ trigonal, qui peut typiquement être comprise entre 1 et 20 nm, par exemple X=2, X=4,X=8 nm.

Les blocs de Sb₂Te₃ présentent typiquement des groupements de cinq couches QL (acronyme de Quintuple Layers) faiblement couplés entre eux, et constitués de plans Te-Sb-Te-Sb-Te perpendiculaires à la direction [001] selon l'indexation hexagonale de la structure trigonale de Sb₂Te₃. Les groupements QL présentent une hauteur de 1,015 nm. La cellule unitaire hexagonale contient 3 QL (c = 3,0458 nm). À l'intérieur d'un groupement QL, Sb et Te sont liés de manière covalente ou métavalente. Les groupements QL sont typiquement séparés par un espacement de 0,275 nm de hauteur. Cet espacement correspond à un pseudo-gap de vdW.

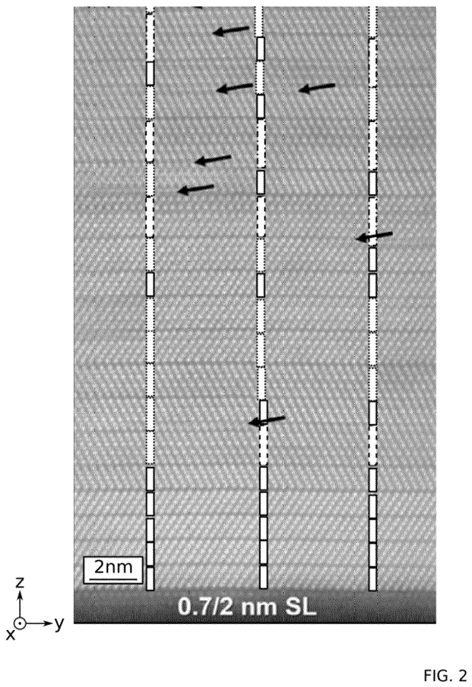

La figure 2 est une image de microscopie électronique en transmission à balayage (STEM, acronyme de Scanning Transmission Electron Microscopy) illustrant un tel empilement 20 formé à partir de blocs de (GeTe)₂ et de Sb₂Te₃ d'épaisseurs respectives 0,7 nm et 2 nm. L'arrangement en groupements QL séparés par des pseudo-gaps de VdW est clairement visible. Les segments en traits pointillés alternés, en grands traits pointillés, en petits traits pointillés et en traits continus correspondent à des alliages ternaires GeₓSb_{y}Te_{z}, respectivement à GST326, GST225, GST124, et aux QL Sb₂Te₃.

L'empilement 20 est typiquement formé à la surface 100 d'un substrat 10 qui peut être à base de silicium, de silicium amorphe, d'oxyde de silicium amorphe. D'autres matériaux sont également envisageables pour le substrat 10, au moins au niveau de sa surface 100, par exemple TiN, WSi, W, TiSiN, TaN et le carbone. Le carbone peut par exemple être avantageusement utilisé en tant que barrière de diffusion dans les dispositifs de mémoire. Selon une possibilité, le substrat 10 comprend une électrode inférieure connectant l'empilement 20.

Une couche d'orientation 11 peut être avantageusement intercalée entre l'empilement 20 et le substrat 10. L'empilement 20 est alors formé à la surface 110 de cette couche d'orientation 11. La couche d'orientation 11 est configurée pour orienter la structure cristalline de l'empilement 20 selon l'axe cristallographique c. Cette couche d'orientation 11 peut se présenter sous forme d'un film parfaitement stœchiométrique de Sb₂Te₃ ou de Bi₂Te₃, d'épaisseur e11 de l'ordre de quelques nanomètres (typiquement 5 nm pour Sb₂Te₃). Cette couche d'orientation 11 peut être formée par dépôt physique en phase vapeur PVD, en utilisant par exemple une méthode de co-pulvérisation de cibles Sb et Te ou Sb₂Te₃ et Te en ajustant les puissances sur chacune des cibles. L'utilisation d'une cible Sb₂Te₃₊ₓ enrichie en Te est également envisageable. Cela permet de compenser un éventuel déficit en tellure lors de la formation de la couche de passivation 11. La couche de passivation 11 peut ainsi présenter une couche de surface non déficitaire ou enrichie en Te formée par exemple par un plan atomique pur de Te.

L'empilement 20 peut être directement formé par épitaxie, par exemple à une température comprise entre 180° et 300°C pour le Sb₂Te₃. Le dépôt épitaxial des différentes couches 21, 22 peut être effectué à partir de l'une des techniques de dépôt suivantes : le dépôt assisté par laser pulsé PLD (Pulsed Laser Deposition), l'épitaxie par jet moléculaire MBE (Molecular Beam Epitaxy), le dépôt physique en phase vapeur PVD (Physical Vapor Deposition), l'épitaxie en phase vapeur à précurseurs organométalliques MOVPE (Molecular Vapor Phase Epitaxy), le dépôt chimique en phase vapeur CVD (Chemical Vapor Deposition), le dépôt par couche atomique ALD (Atomic Layer Deposition), le dépôt par évaporation, le dépôt chimique en phase vapeur à précurseurs organométalliques MOCVD (Molecular Chemical Vapor Deposition).

Alternativement, l'empilement 20 peut être formé indirectement à partir d'un dépôt amorphe des couches 21, 22, suivi d'un recuit de cristallisation. Dans ce cas, la couche d'orientation 11 est nécessaire pour permettre l'orientation de la structure multicouches de l'empilement selon l'axe cristallographique c lors de la cristallisation.

Selon une possibilité préférée, la surface 100 du substrat 10 peut être passivée par un apport en tellure ou en antimoine par exemple. Cela améliore l'épitaxie de la couche d'orientation 11 et/ou de la première couche 21. Selon un exemple, l'apport de tellure lors du dépôt d'une couche d'orientation 11 à base de Sb₂Te₃ ou de Bi₂Te₃ permet de passiver la surface 100 de croissance par une couche de surface riche en Te se terminant par une monocouche atomique de Te. Cela permet notamment de réaliser une épitaxie de Van der Waals bien orientée sur tout type de substrat 10.

Comme illustré à la figure 2 par les flèches noires, le super réseau 0,7/2 nm présente après épitaxie de nombreuses fautes d'empilement. Ces fautes d'empilement sont majoritairement situées au niveau des gaps de van der Waals, entre les blocs de matériau PCM.

Il a été observé dans le cadre du développement de la présente invention que la densité de ces défauts structuraux est liée :
- à l'écart d'énergie entre l'hétérostructure obtenue après épitaxie et la structure de composition chimique équivalente se trouvant à l'équilibre thermodynamique. Cet écart dépend notamment de la nature des blocs de GST formés dans le SL par mélange local des films de GeTe et de Sb₂Te₃. Cet écart à l'équilibre thermodynamique dépend *in fine* de l'énergie nécessaire à la diffusion des espèces chimiques permettant de tendre vers l'empilement de blocs de GST de plus basse énergie ;
- à un déficit local en Te dans la structure, qui induit la formation locale de défauts bicouches ou « bilayers defects » ;
- à la température de dépôt, qui empêche une mobilité atomique suffisante pour accommoder les défauts ;
- à l'épaisseur des couches de Sb₂Te₃.

Un principe de l'invention consiste donc à effectuer après la formation de l'empilement un recuit adapté, typiquement de l'ordre de 400°C à 500°C, par exemple 450°C, pendant une durée de plusieurs minutes à plusieurs heures pour amener la structure telle que déposée dans son état de plus basse énergie. Cet état de basse énergie correspond à une structure parfaitement orientée selon son axe c présentant des blocs pour lesquels la diffusion des espèces chimique est achevée et séparés par des pseudo gaps de vdW, sans ou avec très peu de fautes d'empilement. Selon un exemple, un empilement 20 du type SL 0.7/2nm de (GeTe)₂/(Sb₂Te₃)₂ est soumis à un recuit de guérison à 450°C pendant 60 min pour former un cristal orienté de GST 124 sans défauts au niveau des gaps de vdW.

Le recuit de guérison est typiquement effectué à une température supérieure à la température de formation de l'empilement 20, par exemple à une température supérieure à 300°C. Avantageusement, le recuit de guérison est effectué à une température compatible avec les étapes d'intégration BEOL, c'est-à-dire à une température inférieure aux températures mises en oeuvre lors de ces étapes d'intégration BEOL, typiquement à une température inférieure ou égale à 500°C. Le recuit de guérison permet de diminuer la densité de défauts structuraux, en particulier de fautes empilement, dans la structure cristalline de l'empilement 20. Les paramètres du recuit de guérison sont de préférence ajustés de façon à obtenir un nombre de défauts après recuit inférieur ou égal à 50 % du nombre de défauts initialement présents dans l'empilement, avant recuit. Selon une possibilité, le nombre de défauts structuraux après recuit de guérison est inférieur ou égal à 60 % du nombre de défauts initial dans l'empilement, de préférence inférieur à 20% voire 10%. Un ou plusieurs recuits de guérison peuvent être effectués successivement. En particulier, si la densité de défauts structuraux n'a pas suffisamment diminué à l'issue du premier recuit de guérison, un deuxième recuit de guérison à une température plus élevée et/ou pendant une durée plus longue peut être effectué.

Les paramètres du ou des recuits de guérison sont pris parmi certains au moins des paramètres suivants : la température, la durée, la courbe d'évolution de la température en fonction du temps, par exemple une rampe de montée ou de descente en température. En modifiant ces paramètres parfaitement classiques, on parvient à la réduction du taux de défauts.

L'état final de la structure et l'efficacité du recuit de guérison peuvent notamment être contrôlés au moyen de la diffraction de rayons X. Ainsi, pour déterminer le taux de défauts on peut par exemple se baser sur une mesure par diffraction des rayons X (DRX). Une analyse dite « Rocking Curve » (ou courbe d'oscillation en français) peut également être effectuée à l'issue du recuit de guérison pour vérifier que les différentes couches de l'empilement sont parallèles au substrat. En particulier, les différentes couches de l'empilement sont considérées comme étant parallèles au substrat lorsque la Rocking Curve d'un pic de Bragg ne dépasse pas la largeur à mi-hauteur de 10°.

Selon une possibilité, l'empilement 20 est encapsulé avant recuit de guérison. Cela permet d'éviter une évaporation du tellure lors du recuit de guérison. Une électrode supérieure peut être formée sur l'empilement. L'empilement 20 peut ainsi être pris en sandwich entre l'électrode inférieure et l'électrode supérieure, de manière à former une cellule mémoire PCM.

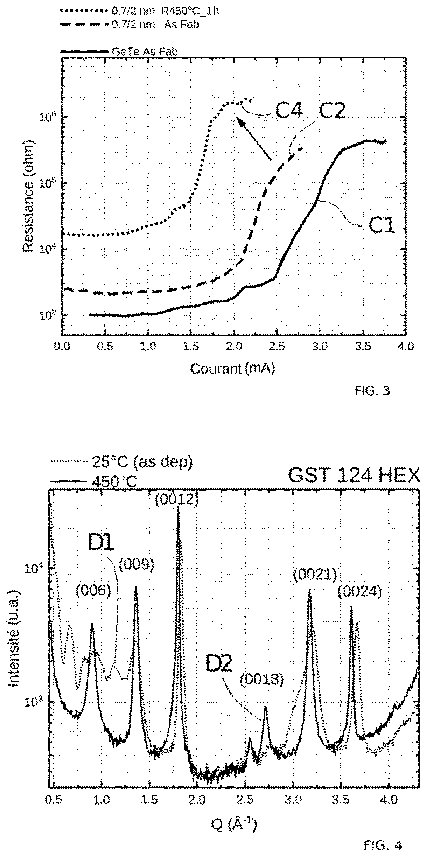

La figure 3 illustre des tests électriques réalisés sur des dispositifs mémoire intégrant différents empilements à changement de phase. R est la valeur mesurée de la résistance de la cellule mémoire en fonction du courant injecté lors de l'application successive de pulses de tension de programmation. La courbe C1 correspond à un empilement PCM de référence (alliage polycristallin de GeTe), sans structuration en super-réseau. La courbe C2 correspond à un empilement iPCM GeTe/Sb₂Te₃ 0,7/2 nm tel qu'illustré à la figure 2. La courbe C4 correspond à un empilement iPCM GeTe/Sb₂Te₃ 0,7/2 nm après recuit de guérison à 450° pendant une heure.

Les meilleures performances, c'est-à-dire les courants de programmation les plus faibles, correspondent à la courbe C4. Il apparaît ainsi que l'empilement iPCM 0,7/2 nm après recuit présente un niveau de performance significativement plus élevé que le même empilement sans recuit de guérison. Ce niveau de performance de l'iPCM 0,7/2 nm après recuit est typiquement comparable à celui d'un empilement iPCM 0,7/8 nm sans recuit.

La microscopie électronique en transmission a montré que la différence majeure dans les structures cristallines initiales des iPCMs 0.7/2 nm et 0.7/8 nm provient de la densité de fautes d'empilement dans leur structure cristalline. En effet, après formation, l'iPCM 0.7/8 nm présente une densité de fautes d'empilement initiale quatre fois plus faible que l'iPCM 0.7/2 nm. Cette différence dans l'ordre de la structure cristalline est également observée par Diffraction des Rayons X (DRX), où la structure 0.7/8 nm présente des pics de Bragg plus étroits et de largeurs comparables ou identiques entre eux contrairement à l'échantillon 0.7/2 nm qui présente avant recuit des pics larges et des pics plus étroits. Cela indique que la structure 0.7/8 nm présente moins de désordre et/ou de défauts que la structure 0.7/2 nm.

La figure 4 présente les diagrammes de diffraction des rayons X pour les iPCM GeTe/Sb₂Te₃ 0.7/2 nm avec et sans recuit de guérison. La courbe D1, correspondant à l'empilement 0.7/2 nm avant recuit, présente des pics larges indiquant une structure cristalline désordonnée. La courbe D2, correspondant à l'empilement 0.7/2 nm après recuit à 450°C pendant 1 heure, présente des pics plus fins de largeur à mi-hauteur homogène. L'indexation de ces pics de Bragg correspond à une phase hexagonale de GST 124 (Ge₁Sb₂Te₄) orientée selon l'axe c. Cette phase correspond à la structure cristalline la plus stable, de plus basse énergie, pour cet empilement.

L'affinement des pics après recuit est attribuable à une baisse du désordre dans la structure cristalline. Le recuit de guérison permet notamment de réduire ou supprimer le nombre de fautes d'empilement dans la structure cristalline de l'empilement iPCM.

Selon une possibilité préférée, une étape de contrôle par diffraction des rayons X est effectuée après le recuit de guérison. Une telle étape est typiquement effectuée sur une pleine plaque, avant la formation des dispositifs mémoire finaux. Avantageusement, le contrôle par DRX est non destructif, et peut être facilement intégré aux étapes de fabrication des dispositifs PCM. Si le diffractogramme obtenu présente des pics bien définis, de largeur à mi-hauteur homogène et indexables, le recuit de guérison est considéré suffisant et les étapes ultérieures de fabrication des dispositifs mémoires peuvent être mises en œuvre. Si le diffractogramme obtenu présente au moins certains pics larges ou mal définis, le recuit de guérison est considéré insuffisant et un deuxième recuit de guérison peut être mis en œuvre, notamment à plus haute température et/ou pendant une durée plus longue. Un ou plusieurs recuits de guérison, suivis d'un ou plusieurs contrôles par DRX, peuvent ainsi être effectués afin d'obtenir un empilement iPCM de bonne qualité cristalline, présentant peu ou pas de défauts structuraux et notamment peu ou pas de fautes d'empilement.

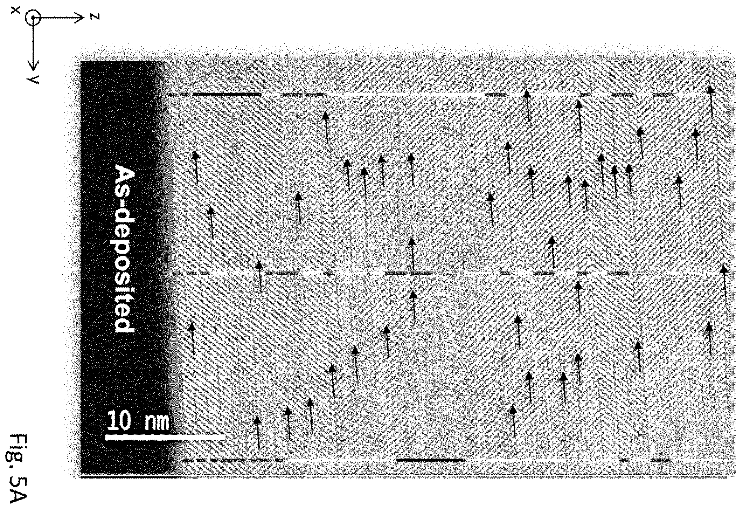

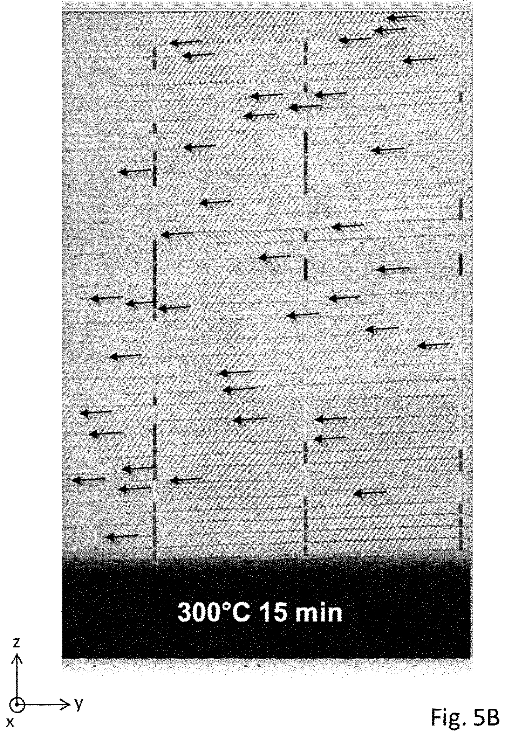

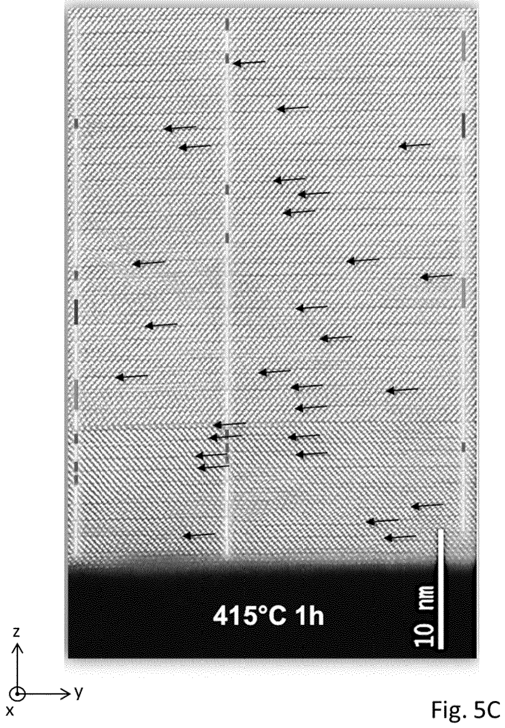

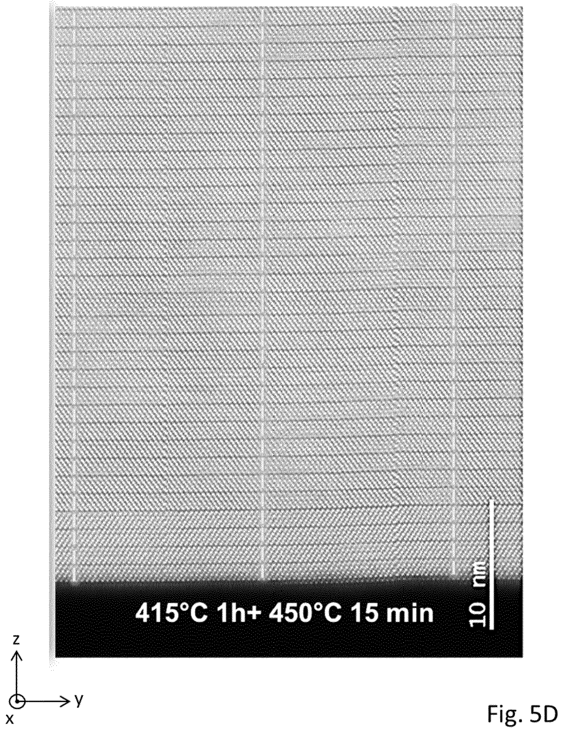

Selon une possibilité, une étape de contrôle par microscopie électronique en transmission est effectuée après le recuit de guérison, alternativement ou en combinaison avec un contrôle par diffraction des rayons X. En effet, dans certains cas, les pics de Bragg du diagramme de diffraction sont totalement affinés alors que certains défauts structuraux subsistent dans l'empilement, notamment lorsque les défauts cristallins se présentent sous forme de bicouches inversées appelées « swapped bilayers ». Les figures 5A, 5B, 5C, 5D illustrent des analyses par microscopie électronique en transmission (TEM) effectuées respectivement sur l'empilement tel que déposé, l'empilement après recuit de guérison à 300°C pendant 15 min, l'empilement après recuit de guérison à 415°C pendant 1h, l'empilement après un premier recuit de guérison à 415°C pendant 1h suivi d'un deuxième recuit de guérison à 450°C pendant 15 min. Les défauts structuraux sont indiqués par des flèches sur les images TEM des figures 5A, 5B, 5C, 5D. Il apparaît que seul l'empilement ayant subi le premier recuit de guérison à 415°C pendant 1h suivi du deuxième recuit de guérison à 450°C pendant 15 min (figure 5D) est exempt de défauts structuraux.

Le diffractogramme obtenu sur l'empilement visible en figure 5C présente des pics de Bragg totalement affinés (non illustré), comme le diffractogramme obtenu sur l'empilement visible en figure 5D (non illustré). Or il apparaît que l'empilement visible en figure 5C présente encore un certain nombre de défauts, notamment de type « swapped bilayers », qui n'ont pas été totalement éliminés à l'issue du recuit de guérison à 415°C pendant 1h. La mise en œuvre d'une analyse complémentaire par microscopie électronique en transmission permet donc avantageusement d'améliorer la détection et la détermination du taux de défauts dans l'empilement, en combinaison ou en alternative à l'analyse par DRX. Cela permet d'évaluer la nécessité d'effectuer ou non des recuits de guérison supplémentaires.

Cette méthode de fabrication peut être étendue à toutes les hétérostructures ou phases possédant des gaps ou pseudo gaps de vdW dans leur structure cristalline. Cette méthode peut être étendue à une grande gamme de matériaux, de techniques de dépôt et d'applications. Les applications nécessitant des matériaux chalcogénures à changement de phase ou à gap de van der Waals peuvent concerner les domaines de la photonique, des mémoires résistives PCM, du neuromorphisme, de la thermoélectricité, des radiofréquences, de l'optique, de la spintronique. L'invention n'est pas limitée aux modes de réalisation précédemment décrits.

## Revendications

1. Procédé de réalisation d'un empilement (20) à changement de phase comprenant au moins :
• une première couche (21) d'un premier matériau A,
• une deuxième couche (22) d'un deuxième matériau B, différent du premier matériau A,
ledit empilement (20) présentant une structure cristallographique en feuillets séparés par des pseudo-gaps de van der Waals,
ledit procédé comprenant au moins les étapes suivantes :
• une fourniture d'un substrat (10),
• une formation de l'empilement (20) sur une surface (100) du substrat (10), ladite formation comprenant une pluralité de formations de premières couches (21) alternées avec une pluralité de formations de deuxièmes couches (22), de sorte à ce que la structure de l'empilement (20) soit multicouches et comprenne une pluralité de premières et deuxièmes couches (21, 22) alternées,
le procédé étant **caractérisé en ce que**, après formation de l'empilement (20), au moins un recuit de guérison est effectué, ledit recuit de guérison étant effectué de sorte que l'empilement (20) présente, après ledit recuit, un taux de défauts nominal inférieur à 50% d'un taux de défauts initial de l'empilement (20), pris avant ledit recuit.

2. Procédé selon la revendication précédente comprenant en outre, après l'au moins un recuit de guérison, une détermination du taux de défauts dans l'empilement (20) basée sur une mesure par diffraction des rayons X (DRX).

3. Procédé selon la revendication précédente dans lequel un recuit de guérison supplémentaire est effectué si le taux de défauts déterminé est supérieur au taux de défauts nominal.

4. Procédé selon l'une quelconque des revendications précédentes comprenant en outre, après l'au moins un recuit de guérison, une pluralité d'étapes d'intégration de l'empilement (20) destinées à former un dispositif à changement de phase à base dudit empilement (20), tel qu'une mémoire à changement de phase ou un convertisseur thermoélectrique.

5. Procédé selon l'une quelconque des revendications précédentes dans lequel des paramètres du recuit de guérison sont choisis de sorte que l'empilement (20) présente, après ledit recuit, un taux de défauts nominal inférieur à 60%, de préférence inférieur à 20%, d'un taux de défauts initial de l'empilement (20), pris avant ledit recuit.

6. Procédé selon l'une quelconque des revendications précédentes comprenant en outre, après formation de l'empilement (20) et avant l'étape de recuit de guérison, une formation d'une couche d'électrode supérieure sur l'empilement (20).

7. Procédé selon l'une quelconque des revendications précédentes dans lequel le matériau A est un matériau bidimensionnel choisi parmi les dichalcogénures de métaux de transition MX2, avec M = Mo, W et X = S, Se ou Te, le Graphène, le Benzène, le Phosphorène, le Germanène, le Silicène, le Stannène, le Borophène, h-BN, ou parmi les alliages de chalcogénures bidimensionnels tels que Sb-Te, Bi-Te, As-Se, As-Te, Ge-Sb-Te et leur alliages, et dans lequel le matériau B est choisi parmi les alliages binaires Ge-Sb, Ga-Sb, Ge-Te, Ge-Se, GeSe2, Sb-Te, Sb-Se, As-Se, As-Te, Sn-Se, Sn-Te, Bi-Se, Bi-Te, Ga-Te, Ga-Se, Pb-Te, In-Se, Pb-Se, Zr-Te, Zr-Se, Ti-Te, Ti-Se, Si-Te, Al-Te, Mo-Te, Mo-Se, W-S, W-Se, les alliages ternaires Ge-Sb-Te, Ge-Se-Te, Ag-Sb-Te, Ge-Bi-Te, Ge-Sb-Se et quaternaire Ge-Sb-Se-Te, et un mélange de ces alliages.

8. Procédé selon l'une quelconque des revendications précédentes dans lequel la première couche à base du matériau A et/ou la deuxième couche à base du matériau B sont déposées par épitaxie de van der Waals.

9. Procédé selon l'une quelconque des revendications précédentes dans lequel le recuit de guérison est effectué à une température inférieure ou égale à 500°C, de préférence inférieure ou égale à 450°C.

10. Procédé selon la revendication précédente dans lequel la température du recuit de guérison est supérieure à une température maximale de formation de l'empilement (20).

11. Procédé selon l'une quelconque des deux revendications précédentes dans lequel la température du recuit de guérison est strictement supérieure à 300°C.

12. Procédé selon l'une quelconque des revendications précédentes comprenant en outre, avant la formation de l'empilement (20), une formation d'une couche d'orientation (11) configurée pour orienter l'empilement (20) selon l'axe cristallographique c, la formation de l'empilement (20) se faisant alors sur une surface (110) de ladite couche d'orientation (11).

13. Procédé selon la revendication précédente dans lequel la couche d'orientation (11) est à base de Sb₂Te₃ ou de Bi₂Te₃ et présente une épaisseur inférieure ou égale à 10 nm.

14. Procédé selon l'une quelconque des deux revendications précédentes dans lequel la formation des première et deuxième couches (21, 22) se fait par dépôt des matériaux A et B sous forme amorphe, et dans lequel la formation de l'empilement (20) comprend en outre, après lesdits dépôts des matériaux A et B sous forme amorphe, un recuit de cristallisation effectué à une température inférieure ou égale à 300°C.

15. Procédé selon l'une quelconque des revendications précédentes dans lequel certaines au moins des premières couches (21) présentent des épaisseurs différentes, et/ou certaines au moins des deuxièmes couches (22) présentent des épaisseurs différentes, de sorte à ce que la structure multicouches de l'empilement (20) soit apériodique.

16. Procédé selon l'une quelconque des revendications précédentes dans lequel le substrat (10) comprend une électrode inférieure configurée pour effectuer un changement de phase de l'empilement (20).

17. Procédé selon l'une quelconque des revendications précédentes dans lequel chaque pseudo-gap de van der Waals séparant deux feuillets de la structure cristallographique se présente sous forme d'un espacement entre deux plans purs d'un même type d'atomes, ledit espacement présentant une dimension normale aux plans inférieure ou égale à deux fois le rayon de van der Waals dudit type d'atomes.

## Patentansprüche

1. Verfahren zur Herstellung eines Stapels (20) mit Phasenwechsel, der mindestens Folgendes umfasst:
• eine erste Schicht (21) aus einem ersten Material A,
• eine zweite Schicht (22) aus einem zweiten Material B, das sich von dem ersten Material A unterscheidet,
wobei der Stapel (20) eine kristallographische Struktur aus Lamellen aufweist, die durch Van-der-Waals-Pseudospalten getrennt sind,
wobei das Verfahren mindestens die folgenden Schritte umfasst:
• Bereitstellen eines Substrats (10),
• Bilden des Stapels (20) auf einer Oberfläche (100) des Substrats (10),
wobei die Bildung eine Vielzahl von Bildungen aus ersten Schichten (21) umfasst, die mit einer Vielzahl von Bildungen aus zweiten Schichten (22) derart abwechseln, dass die Struktur des Stapels (20) mehrschichtig ist und eine Vielzahl abgewechselter erster und zweiter Schichten (21, 22) umfasst,
Verfahren **dadurch gekennzeichnet, dass** nach dem Bilden des Stapels (20) mindestens ein Heilungstempern erfolgt, wobei das Heilungstempern derart erfolgt, dass der Stapel (20) nach dem Tempern eine nominale Defektrate kleiner als 50 % einer anfänglichen Defektrate des Stapels (20), vor dem Tempern genommen, aufweist.

2. Verfahren nach dem vorstehenden Anspruch, das außerdem nach dem mindestens einen Heilungstempern ein Bestimmen der Defektrate in dem Stapel (20) basierend auf einer Messung durch Röntgenbeugung (DRX) umfasst.

3. Verfahren nach dem vorstehenden Anspruch, wobei ein zusätzliches Heilungstempern erfolgt, wenn die bestimmte Defektrate größer als die nominale Defektrate ist.

4. Verfahren nach einem der vorstehenden Ansprüche, das außerdem nach dem mindestens einen Heilungstempern eine Vielzahl von Integrationsschritten des Stapels (20) umfasst, die dazu bestimmt sind, eine Phasenwechselvorrichtung basierend auf dem Stapel (20) zu bilden, wie einen Phasenwechselspeicher oder einen thermoelektrischen Wandler.

5. Verfahren nach einem der vorstehenden Ansprüche, wobei die Parameter des Heilungstemperns derart ausgewählt werden, dass der Stapel (20) nach dem Tempern eine nominale Defektrate kleiner als 60 %, bevorzugt kleiner als 20 % einer anfänglichen Defektrate des Stapels (20), vor dem Tempern genommen, aufweist.

6. Verfahren nach einem der vorstehenden Ansprüche, das außerdem nach dem Bilden des Stapels (20) und vor dem Schritt des Heilungstemperns ein Bilden einer oberen Elektrodenschicht auf dem Stapel (20) umfasst.

7. Verfahren nach einem der vorstehenden Ansprüche, wobei das Material A ein zweidimensionales Material ist, das ausgewählt ist aus Übergangsmetalldichalkogeniden MX2, mit M = Mo, W und X = S, Se oder Te, Graphen, Benzol, Phosphoren, Germanen, Silicen, Stanen, Borophen, h-BN oder aus zweidimensionalen Chalkogenidlegierungen wie Sb-Te, Bi-Te, As-Se, As-Te, Ge-Sb-Te und deren Legierungen, und wobei das Material B ausgewählt ist aus den binären Legierungen Ge-Sb, Ga-Sb, Ge-Te, Ge-Se, GeSe2, Sb-Te, Sb-Se, As-Se, As-Te, Sn-Se, Sn-Te, Bi-Se, Bi-Te, Ga-Te, Ga-Se, Pb-Te, In-Se, Pb-Se, Zr-Te, Zr-Se, Ti-Te, Ti-Se, Si-Te, Al-Te, Mo-Te, Mo-Se, W-S, W-Se, den ternären Legierungen Ge-Sb-Te, Ge-Se-Te, Ag-Sb-Te, Ge-Bi-Te, Ge-Sb-Se und der quaternären Legierung Ge-Sb-Se-Te sowie einer Mischung dieser Legierungen.

8. Verfahren nach einem der vorstehenden Ansprüche, wobei die erste Schicht auf Basis des Materials A und/oder die zweite Schicht auf Basis des Materials B durch Van-der-Waals-Epitaxie abgeschieden werden.

9. Verfahren nach einem der vorstehenden Ansprüche, wobei das Heilungstempern bei einer Temperatur kleiner oder gleich 500 °C, bevorzugt kleiner oder gleich 450 °C erfolgt.

10. Verfahren nach dem vorstehenden Anspruch, wobei die Temperatur des Heilungstemperns größer ist als eine maximale Bildungstemperatur des Stapels (20).

11. Verfahren nach einem der beiden vorstehenden Ansprüche, wobei die Temperatur des Heilungstemperns strikt größer als 300 °C ist.

12. Verfahren nach einem der vorstehenden Ansprüche, das außerdem vor dem Bilden des Stapels (20) ein Bilden einer Orientierungsschicht (11) umfasst, die dazu konfiguriert ist, den Stapel (20) gemäß der kristallographische Achse c auszurichten, wobei das Bilden des Stapels (20) auf einer Oberfläche (110) der Orientierungsschicht (11) erfolgt.

13. Verfahren nach dem vorstehenden Anspruch, wobei die Orientierungsschicht (11) auf Sb2Te3 oder Bi2Te3 basiert und eine Dicke kleiner oder gleich 10 nm aufweist.

14. Verfahren nach einem der beiden vorstehenden Ansprüche, wobei das Bilden der ersten und der zweiten Schicht (21, 22) durch Abscheiden der Materialien A und B in amorpher Form erfolgt, und wobei das Bilden des Stapels (20) außerdem nach den Abscheidungen der Materialien A und B in amorpher Form ein Kristallisationstempern umfasst, das bei einer Temperatur kleiner oder gleich 300 °C erfolgt.

15. Verfahren nach einem der vorstehenden Ansprüche, wobei mindestens bestimmte der ersten Schichten (21) unterschiedliche Dicken aufweisen und/oder mindestens bestimmte der zweiten Schichten (22) unterschiedliche Dicken derart aufweisen, dass die mehrschichtige Struktur des Stapels (20) aperiodisch ist.

16. Verfahren nach einem der vorstehenden Ansprüche, wobei das Substrat (10) eine untere Elektrode umfasst, die dazu konfiguriert ist, einen Phasenwechsel des Stapels (20) durchzuführen.

17. Verfahren nach einem der vorstehenden Ansprüche, wobei jede Van-der-Waals-Pseudospalte, die zwei Lamellen der kristallographischen Struktur trennt, die Form einer Beabstandung zwischen zwei reinen Ebenen desselben Typs von Atomen aufweist, wobei die Beabstandung eine normale Abmessung zu den Ebenen kleiner oder gleich dem Zweifachen des Van-der-Waals-Radius des Typs von Atomen aufweist.

## Claims

1. Method for manufacturing a phase change stack (20) comprising at least:
• a first layer (21) of a first material A,
• a second layer (22) of a second material B, different from the first material A,
said stack (20) having a crystallographic structure made of layers separated by van der Waals pseudo-gaps,
said method comprising at least the following steps:
• a provision of a substrate (10),
• a formation of the stack (20) on a surface (100) of the substrate (10), said formation comprising a plurality of formations of first layers (21), alternated with a plurality of formations of second layers (22), such that the structure of the stack (20) is multilayer and comprises a plurality of first and second alternate layers (21, 22),
the method being **characterised in that**, after formation of the stack (20), at least one curing annealing is carried out, said curing annealing being carried out such that the stack (20) has, after said annealing, a nominal defect rate less than 50% of an initial defect rate of the stack (20), taken before said annealing.

2. Method according to the preceding claim further comprising, after the at least one curing annealing, a determination of the defect rate in the stack (20) based on an X-ray diffraction (XRD) measurement.

3. Method according to the preceding claim, wherein an additional curing annealing is carried out if the determined defect rate is greater than the nominal defect rate.

4. Method according to any one of the preceding claims, further comprising, after the at least one curing annealing, a plurality of stack (20) integration steps, intended to form a phase change device with the basis of said stack (20), such as a phase change memory or a thermoelectric converter.

5. Method according to any one of the preceding claims, wherein parameters of the curing annealing are chosen, such that the stack (20) has, after said annealing, a nominal defect rate less than 60%, preferably less than 20%, of an initial defect rate of the stack (20), taken before said annealing.

6. Method according to any one of the preceding claims, further comprising, after formation of the stack (20) and before the curing annealing step, a formation of an upper electrode layer on the stack (20).

7. Method according to any one of the preceding claims, wherein the material A is a two-dimensional material chosen from among transition metal dichalcogenides MX₂, with M = Mo, W and X = S, Se or Te, Graphene, Benzene, Phosphorene, Germanene, Silicene, Stanene, Borophene, h-BN, or among two-dimensional chalcogenide alloys, such as Sb-Te, Bi-Te, As-Se, As-Te, Ge-Sb-Te and their alloys, and wherein the material B is chosen from among Ge-Sb, Ga-Sb, Ge-Te, Ge-Se, GeSe2, Sb-Te, Sb-Se, As-Se, As-Te, Sn-Se, Sn-Te, Bi-Se, Bi-Te, Ga-Te, Ga-Se, Pb-Te, In-Se, Pb-Se, Zr-Te, Zr-Se, Ti-Te, Ti-Se, Si-Te, Al-Te, Mo-Te, Mo-Se, W-S, W-Se binary alloys, Ge-Sb-Te, Ge-Se-Te, Ag-Sb-Te, Ge-Bi-Te, Ge-Sb-Se ternary alloys and Ge-Sb-Se-Te quaternary alloy, and a mixture of these alloys.

8. Method according to any one of the preceding claims, wherein the first layer with the basis of the material A and/or the second layer with the basis of the material B are deposited by van der Waals epitaxy.

9. Method according to any one of the preceding claims, wherein the curing annealing is carried out at a temperature less than or equal to 500°C, preferably less than or equal to 450°C.

10. Method according to the preceding claim, wherein the temperature of the curing annealing is greater than a maximum stack (20) formation temperature.

11. Method according to any one of the two preceding claims, wherein the temperature of the curing annealing is strictly greater than 300°C.

12. Method according to any one of the preceding claims further comprising, before the formation of the stack (20), a formation of an orientation layer (11) configured to orient the stack (20) about the crystallographic axis *c*, the formation of the stack (20) thus being done on a surface (110) of said orientation layer (11).

13. Method according to the preceding claim, wherein the orientation layer (11) is Sb₂Te₃- or Bi₂Te₃-based, and has a thickness less than or equal to 10nm.

14. Method according to any one of the two preceding claims, wherein the formation of the first and second layers (21, 22) is done by deposition of the materials A and B and in amorphous form, and wherein the formation of the stack (20) further comprises, after said depositions of the materials A and B in amorphous form, a crystallisation annealing carried out at a temperature less than or equal to 300°C.

15. Method according to any one of the preceding claims, wherein at least some of the first layers (21) have different thicknesses, and/or at least some of the second layers (22) have different thicknesses, such that the multilayer structure of the stack (20) is aperiodic.

16. Method according to any one of the preceding claims, wherein the substrate (10) comprises a lower electrode configured to make a phase change of the stack (20).

17. Method according to any one of the preceding claims, wherein each van der Waals pseudo-gap separating two layers of the crystallographic structure is presented in the form of a spacing between two pure planes of one same atom type, said spacing having a dimension normal to the planes less than or equal to twice the van der Waals radius of said atom type.
